# EUROPEAN PATENT APPLICATION

(11) **EP 0 801 375 A2**
(43) Date of publication of application: **15.10.1997**
(21) Application number: 97301403.8
(22) Date of filing: 04.03.1997
(51) Int. Cl.: G09G 1/16

(54) **A memory with optimized memory space and wide data input/output and systems and methods using the same**

(30) Priority: 05.03.1996 US 611061
(71) Applicant: CIRRUS LOGIC, INC., Fremont, California 94538 (US)
(72) Inventor: Taylor, Ronald T., Grapevine, Texas 76051 (US); Rao, G.R. Mohan, Dallas, Texas 75252 (US); Runas, Michael E., McKinney, Texas (US)
(74) Representative: Cross, Rupert Edward Blount

(57) **Abstract**

A single chip frame buffer 302 for use in a display subsystem 300 operable to display images as frames of preselected numbers of pixels, each pixel defined by a preselected number of bits of pixel data. Single chip frame buffer 302 includes an array of memory cells, a number of the memory cells in the array preselected to store pixel data defining a display frame and minimize excess cells. A data port is included having a predetermined number of terminals, the predetermined number of terminals being substantially equal to a number of lines of an associated bus.

## Description

### TECHNICAL FIELD OF THE INVENTION

The present invention relates in general to electronic memories and in particular to a memory with optimized memory space and systems and methods using the same.

### BACKGROUND OF THE INVENTION

Most memory subsystems employed in currently available computer systems are either constructed from static random access memory devices (SRAMs) or dynamic random access memory devices (DRAMs) . Each type of memory device has advantages and disadvantages, and as a result DRAMs and SRAMs are typically restricted to different applications. Specifically, SRAMs are faster and are typically used in those applications where fast access times and high bandwidth are critical, such as in cache memories. SRAMs however consume more power, are more expensive to fabricate, and provide fewer cells (bits) per given chip space. On the other hand, while slower than SRAMs, DRAMs are typically less expensive, consume substantially less power, and provide more bits in the same chip space (i.e. have a higher cell density). DRAMs are typically used to construct those memory subsystems, such as system memories and display frame buffers, where power conservation and cell density are more critical than speed. In most computing systems, it is these subsystems which dominate the system architecture, and hence, DRAMs remain the prevalent type of memory device on the market.

In the vast majority of presently available commercial DRAMs, the maximum number of available data input/output pins is 16, allowing access to a maximum of 16 bits per random access or page cycle per chip. This presents a problem in the construction of state of the art computing systems, where the data buses are as wide as 64 or 72 bits. For example, to support a 64-bit wide data bus, four parallel "by 16" devices are required per bank of memory. Multiple chips in turn require additional board space, increase power consumption and increase the number of required interconnections on the printed circuit boards. Further, since monolithic DRAMs are constructed in fixed sizes, such as 512 Bytes, memory space is often wasted. For example, assuming 512 KByte devices organized as 256K x 16 are used, each memory bank will require four devices with a minimum capacity of 2 MBytes to support a 64-bit wide data bus. To Increase memory capacity and still support a 64-bit bus, additional 2 MByte banks must be added, even if intermediate capacities, such as 1.3 or 1.7 MBytes are only required.

Excess memory space is particularly acute in the frame buffer (display memory) context. Currently, the typical frame buffer capable of fully supporting a 64-bit data bus is constructed from four standard 256K by 16 (512 KByte) devices. The minimum storage space is again 2 Mbytes, even though the majority displays found in commercial PCs only require 1.3 MBytes of frame buffer memory capacity. For example, a 1.3 MByte memory is sufficient to meet the on-screen and off-screen requirements of a 640 x 480 x 24 bit color display or a 1,024 x 768 x 16 or 8 bit color display.

Additionally, timing and control becomes more complex during frame buffer design as a result of the fact that the data ports of currently available DRAMs are limited to 16 pins. Specifically, typical display systems sometimes operate on display data with an 8 bits per pixel resolution (due to VGA legacy). Thus, to efficiently modify a display image on a pixel by pixel basis, the dispiay controller must be able to write to memory in 8-bit words. In the system described above in which four 256K by 16 devices are used, the controller must be able to enable 8 pins from the 16-pin data port from a given one of the four chips during a write operation. Often, 8-bit write capability is achieved through the use of multiple row address strobes and/or column address strobes. These schemes complicate address timing and control, increase display controller overhead and require additional pins and related interconnect to transmit the appropriate /RAS and /CAS signals between controller and eacn memory chip.

Thus, the need has arisen for circuits and methods useful for the efficient design and construction of memory subsystems. In particular, such circuits and methods should be applicable to the design and construction of DRAM frame buffer memories, although not necessarily limited thereto. In implementing such devices, excess memory space should be substantially reduced and the address timing substantially simplified.

### SUMMARY OF THE INVENTION

According to one embodiment of the principles of the present invention, a single chip frame buffer is provided for use in a display subsystem operable to display images as frames of a preselected number of pixels, each pixel defined by a preselected number of bits of pixel data. The single chip frame buffer includes an array of memory cells, a number of memory cells in the array preselected to store pixel data defining a display frame and to minimize excess cells. A data port is provided as part of the single chip frame buffer which has a predetermined number of terminals, the predetermined number of terminals being substantially equal to a number of lines of a selected data bus.

According to a second embodiment of the principles of the present invention, a frame buffer is provided fabricated on a single chip which includes a memory array having a capacity preselected to contain a frame of display data and an amount of additional information with minimal unused memory space, and a data port for supporting an entire associated data bus.

The principles of the present invention are also embodied in a display system comprising a display device and a single chip frame buffer. The display device is operable to display images as frames of a predetermined number of pixels, each pixel defined by a word of pixel data. The single chip frame buffer has a storage capacity optimized to store words of pixel data defining one of the frames with a minimum number of excess cells.

The principles of the present invention are also embodied in methods for constructing a frame buffer. According to one such method, an array of memory cells is provided, the size of which is selected as required to store a frame of pixel data defining an image to be displayed on a selected display device with minimal excess cells. A selected number of terminals are provided for accessing the array, the number of terminals selected as required for the frame buffer to independently support a associated data bus.

Memories embodying the principles of the present invention have substantial advantages over the prior art. Among other things, by tailoring the amount of memory storage capacity to meet the requirements for a given application, excess capacity is significantly reduced or even eliminated. Further, by providing a single chip device with a wide data port, for instance a 64-bit wide data port, the number of chips required to service a corresponding data bus is reduced from several chips to one. By reducing the number of chips required for the frame buffer, board space is saved, power consumption reduced and the access timing, especially for pixel by pixel modifications, simplified.

The foregoing has outlined rather broadly the features and technical advantages of the present invention in order that the detailed description of the invention that follows may be better understood. Additional features and advantages of the invention will be described hereinafter which form the subject of the claims of the invention. It should be appreciated by those skilled in the art that the conception and the specific embodiment disclosed may be readily utilized as a basis for modifying or designing other structures for carrying out the same purposes of the present invention. It should also be realized by those skilled in the art that such equivalent constructions do not depart from the spirit and scope of the invention as set forth in the appended claims.

### BRIEF DESCRIPTION OF THE DRAWINGS

For a more complete understanding of the present invention, and the advantages thereof, reference is now made to the following descriptions taken in conjunction with the accompanying drawings, in which:
FIGURE 1 is a high level functional block diagram of a personal computing system architecture embodying the principles of the present invention;
FIGURE 2 is a more detailed functional block diagram of a conventional display controller - frame buffer memory subsystem;
FIGURE 3 is a more detailed functional block diagram of a display controller - frame buffer subsystem according to the principles of the present invention;
FIGURE 4 is a functional block diagram of a frame buffer memory according to the principles of the present invention; and
FIGURE 5 is a top plan with of a preferred packaging and pin configuration of the frame buffer shown in FIGURE 4.

### DETAILED DESCRIPTION OF THE INVENTION

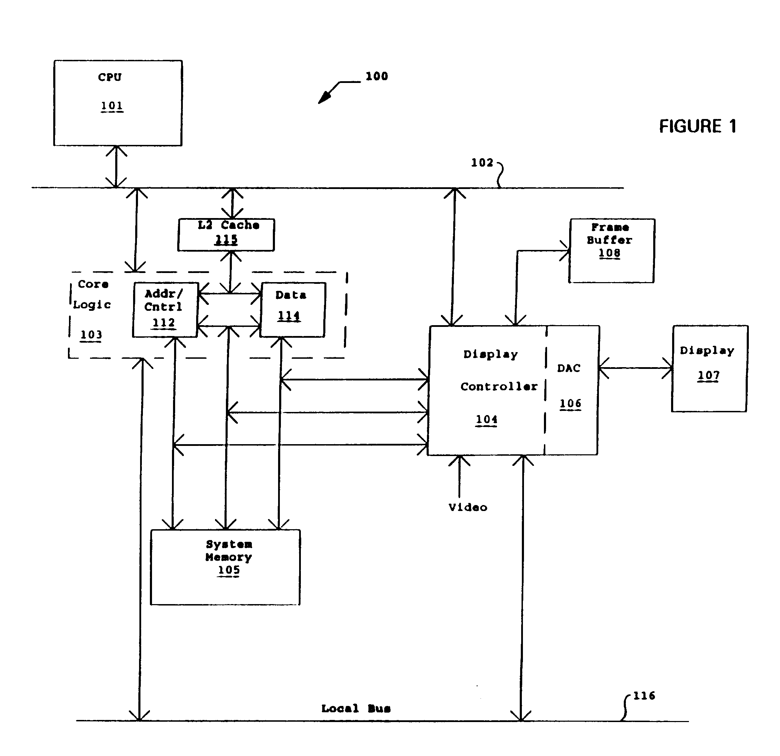

The principles of the present invention and their advantages are best understood by referring to the illustrated embodiment depicted in FIGURES 1-5 of the drawings, in which like numbers designate like parts. While memory devices embodying the principles of the present invention are useful in a wide number of applications, for purposes of illustration, such memory devices will be described in conjunction with a basic processing system architecture typically employed in personal computers.

FIGURE 1 is a high level functional block diagram of portion of a processing system 100. System 100 includes a central processing unit 101, a CPU local bus 102, core logic 103, a display controller 104, a system memory 105, a digital to analog converter (DAC) 106, frame buffer 108, a display device 107.

CPU 101 is the "master" which controls the overall operation of system 100. Among other things, CPU 101 performs various data processing functions and determines the content of the graphics data to be displayed on display unit 107 in response to user commands and/or the execution of application software. CPU 101 may be for example a general purpose microprocessor, such as an Intel Pentium™, PentiumPro™ class microprocessor or the like, used in commercial personal computers. CPU 101 communicates with the remainder of system 100 via CPU local bus 102, which may be for example a special bus, or a general bus. As discussed further below, bus 102 may be used to implement the novel memory interface of the present invention.

Core logic 103, under the direction of CPU 101, controls the exchange of data, addresses, control signals and instructions between CPU 101, display controller 104, and system memory 105. Core logic 103 may be any one of a number cf commercially available core logic chip sets designed for compatibility with the remainder of the system, and in particular with CPU 101. One or more core logic chips, such as chip 112 in the illustrated system, are typically "address and system controller intensive" while one or more core logic chips, such as chip 114 in FIGURE 1, are "data intensive." Address intensive core logic chip 112 generally: interfaces CPU 101 with the address path of CPU bus 102; maintains cache memory, including the cache tags, set associative cache tags and other data necessary to insure cache coherency; performs cache "bus snooping"; generates the control signals required for DRAMs in the system memory or cache; and controls general management transactions. Data intensive chip 114 generally: interfaces CPU 101 with the data path of CPU bus 102; issues cycle completion responses to address chip 112 or CPU 101; may abort operations if their cycles are incomplete; and arbitrates for the data path of bus 102.

CPU 101 can directly communicate with core logic 103 or through an external (L2) cache 115. L2 cache 115 may be for example a 256K Byte fast SRAM device(s). It should be noted that CPU 101 can also include on-board (L1) cache, typically up to 16 kilobytes.

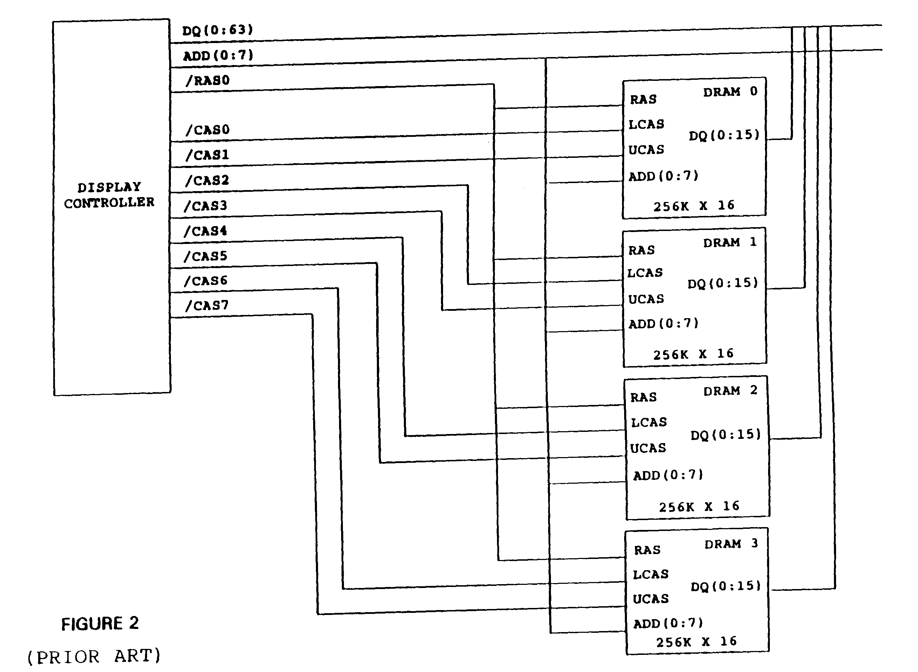

Display controller 104 may be any one of a number of commercially available VGA display controllers modified as required to interface with memory 200, when the principles of the present invention are applied to the display controller/frame buffer interface. For example, display controller 104 may be based on one of the Cirrus Logic CL-GD754x series of display controllers. The structure and operation of such controllers is described in *CL-GD754x Application Book,* Rev 1.0, November 22, 1994, and *CL-GD7542 LCD VGA Controller Preliminary Data Book,* Rev. 1.0.2, June 1994, both available from Cirrus Logic, Inc., Fremont, California, and incorporated herein by reference. Display controller 104 may receive data, instructions and/or addresses from CPU 101 either through core logic 103 or directly from CPU 101 through CPU local bus 102. Data, instructions, and addresses are exchanged between display controller 104 and system memory 105 through core logic 103. Further, addresses and instructions may be exchanged between core logic 103 and display controller 104 via a local bus 116 which may be for example a PCI local bus. Additionally, local bus 116 may be designed and constructed to effectuate the novel interface described below in conjunction with the memory of FIGURE 2.

Generally, display controller 104 controls screen refresh, executes a limited number of graphics functions such as line draws, polygon fills, color space conversion, display data interpolation and zooming, and video streaming, and handles other ministerial chores such as power management. Most importantly, display controller 104 controls the raster of pixel data from frame buffer 108 to display unit 107 during screen refresh and interfaces CPU 101 and frame buffer 108 during display data update. Video data may be directly input into display controller 104.

Digital to analog converter 106 receives digital data from controller 104 and outputs the analog data to drive displays 107a and 107b (when used)in response. In the illustrated embodiment, DAC 106 is integrated with display controller 104 onto a single chip. Depending on the specific implementation of system 100, DAC 106 may also include a color palette, YUV to RGB format conversion circuitry, and/or X- and Y- zooming circuitry, to name a few options. Displays 107 may be for example a CRT unit, a liquid crystal display, electroluminescent display, plasma display, or other type of display device which displays images on a screen as a plurality of pixels. It should also be noted that in alternate embodiments, "display" 107 may be another type of output device such as a laser printer or similar document view/print appliance.

The data paths in system 100 will vary with each design. For example, system 100 may be a "64-bit"or "72-bit" system. Assume for discussion purposes that a 64-bit system is chosen. Then, each of the data connections, including the data paths of CPU bus 102 and PCI bus 116, the data paths through core logic 103 to system memory 109 and display controller 104, and the data interconnection between display controller 104 and frame buffer 108, are all 64 bits wide. It should be noted that the address interconnections will vary depending on the size of the memory and such factors as the need to support data byte select, error detection and correction, and virtual memory operations.

FIGURE 2 generally depicts a typical conventional frame buffer organization and its interface with an associated display controller. The depicted subsystem includes a 64-bit data bus supported by four 256K by 16 dynamic random access memory devices (DRAMs). As is well known in the art, each of the DRAMs is contained in a package which includes a 16-pin wide data port (DQ), an 8-pin address port, a /RAS input pin, and upper-byte and lower-byte /CAS input pins (UCAS and LCAS, respectively). Each DRAM also will normally include output enable (/OE) and write (/WE) input pins which receive read/write control signals from the controller. The output enable and write enable pins on each DRAM and the corresponding interconnect with the controller are not shown in FIGURE 2 for brevity and clarity.

In addition to generating addresses for reading and writing data to locations within the frame buffer, the controller in the subsystem of FIGURE 2 generates a row address strobe, /RAS0, and eight (8) column address strobes /CAS0 - /CAS 7. The row address strobe controls the row address latching into the four DRAMs and generally times the precharge and active cycles of the DRAMs. Two of the eight column address strobes are presented to each DRAM for column address latching, one to the LCAS pin for independently accessing the lower byte and the other to the UCAS pin for independently accessing the upper byte of each 16-bit location. By selective presentation of the column address strobes along with the addresses presented on the address bus, the display controller can thus write on a pixel by pixel basis.

As is apparent from FIGURE 2, conventional frame buffer organization and control is subject to substantial disadvantages. Among other things, four chips and their packaging are required to support a 64-bit bus. Each packaged chip adds cost to the system, consumes board space and increases the required interconnect with the controller. Further, while other byte-addressing schemes using /RAS and/or /CAS are known in the art,they all present the same problems: additional signals with specific timings must be generated in the controller and then routed to the appropriate DRAMs. Finally, the multiple-chip DRAM of FIGURE 2 provides a minimum storage capacity of 2 Mbytes, even though less than 1.5 Mbytes is all that is required to accommodate the on-screen and off-screen needs of the largest and widely used commercial PC displays (i.e. 1024 x 1280 by 8 bits/pixel).

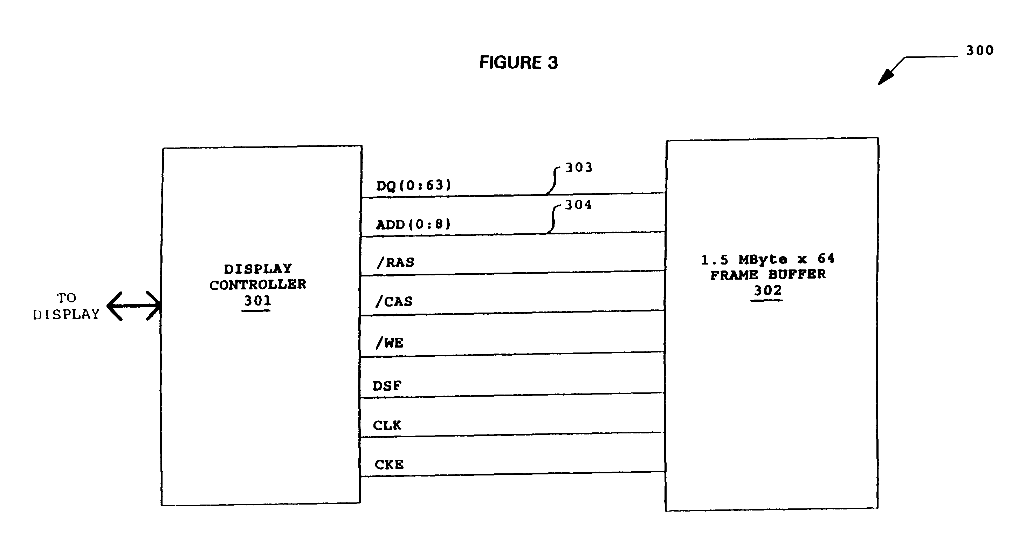

FIGURE 3 is a functional block diagram depicting a memory subsystem 300 embodying the principles of the present invention. Subsystem 300 includes a display controller 301 and a frame buffer 302. In one application, display controller 301 and frame buffer 302 may be employed as display controller 104 and frame buffer 108 in system 100.

According to the principles of the present invention, frame buffer 302 has a storage capacity (i.e DRAM cell array size) optimized to meet the display data storage requirements of display controller 301 and the associated display device with minimal excess capacity. In the illustrated embodiment, frame buffer 302 is a 1.5 MByte device in a single package which can provide for the approximately 1.3 MBytes of on-screen memory required for a 1024 x 1280 x 8 bit/pixel display and 200 KBytes of memory for such uses as icon storage and/or off-screen memory.

The data port (DQ) of single-chip frame buffer 302 and the frame buffer - display controller data path 303 are 64 bits wide according to the principles of the present invention. In the illustrated embodiment, the address path (bus) 304 is 9 bits wide. Frame buffer 302 includes a single /RAS and a single /CAS input. A write enable input /WE is provided for read/write control. Timing of the access and control cycles of frame buffer 302 is controlled by the system master CLK and a clock enable signals CKE. A DSF input allows for the input of a special function enable signal for performing, among other things, write per bit operations.

Single-chip frame buffers, such as frame buffer 302, embodying the principles of the present invention have a number of substantial advantages over the prior art. Among other things, since only a single package is required to service a 64-bit bus, less board space is consumed, the board level interconnect is simpler and presents less loading, and the display subsystem cost is reduced. Further, since the storage capacity is tailored to meet the requirements of the display subsystem, wasted memory space is substantially reduced or eliminated. In the 1.5 MByte memory of the illustrated embodiment, a full 1/2 MByte of memory, which is wasted in the prior art systems such as that shown in FIGURE 2, is eliminated. Finally the single chip frame buffer with a 64-bit data pinout substantially simplifies the address timing requirements and reduces the processing overhead of the associated display controller. In contrast to the system of FIGURE 2 which requires 8 column address strobes for pixel by pixel writing, the present system requires only one /RAS signal and one /CAS signal. With the present invention a single /RAS signal and a single /CAS signal, in conjunction with the DSF bit and a mask received at the input port, is sufficient to provide for pixel by pixel data modification.

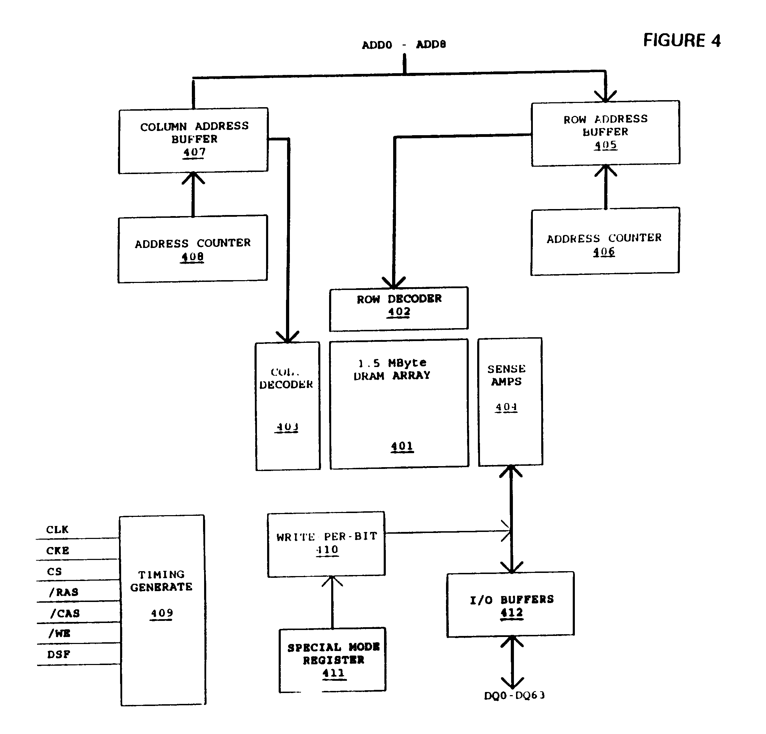

FIGURE 4 is a high level functional block diagram of a preferred architecture for implementing frame buffer 302. Frame buffer 302 includes and array of DRAM cells 401, which in the illustrated embodiment has a capacity of 1.5 MBytes. Array 401 is associated with a row decoder 402, column decoder 403 and sense amplifiers 404, each of which is constructed from dynamic circuitry known in the art.

Address bits received from address bus 304 are input into a row address buffer 405 and a column address buffer 407. In the preferred embodiment, the row address and column address bits are received word-serial from a multiplexed address bus 304 and latched-in with /RAS and /CAS respectively. Address counters 406 and 408 are provided to internally increment from the received row and column addresses for implementing refresh and page mode access.

Timing generators 409 receive the incoming clocks and control bits and generate and distribute the requisite clock and control signals. Write-per-bit circuitry 410 and a special mode register allow for selected masking of bits being written to array 401 through input/output buffers 412. I/O buffers 412 allow for the input and output of 64-bit words according to the preferred embodiment of the present invention.

The write-per-bit function allows for pixel by pixel modification of display data. Write-per-bit is implemented using a 64-bit mask register within I/O buffers 412. The mask is loaded during a given active cycle by setting the DSF pin high, presenting a corresponding opcode at the address pins, and presenting a 64-bit mask at the data pins DQ0 - DQ63. During a subsequent selected active cycle(s) the DSF pin is set high to activate the mask to perform a masked write.

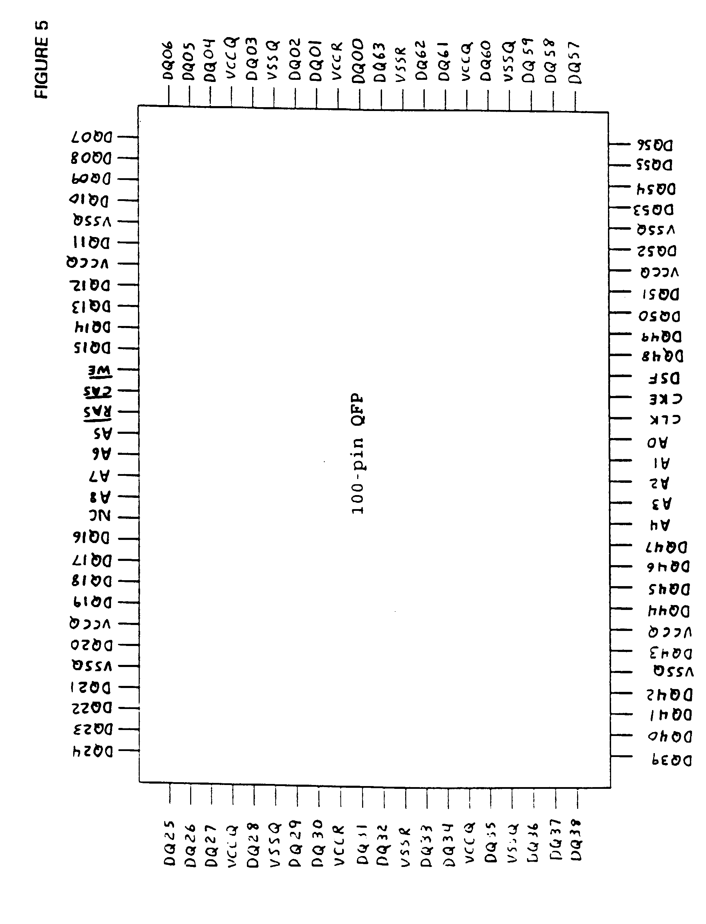

Single-chip frame buffers according to the present invention can be packaged using any one of a number of packaging options. Preferably, a 100-pin QFP package is used with the pin assignments substantially as shown in FIGURE 5.

Although the present invention and its advantages have been described in detail, it should be understood that various changes, substitutions and alterations can be made herein without departing from the spirit and scope of the invention as defined by the appended claims.

## Claims

1. A single-chip frame buffer for use in a display subsystem operable to display images as frames of a preselected number of pixels, each pixel defined by a preselected number of bits of pixel data, comprising:
an array of memory cells, a number of said memory cells in said array preselected to store pixel data defining a said frame and to minimize excess cells; and
a data port having a predetermined number of terminals, said predetermined number of terminals being substantially equal to a number of lines of a selected data bus.

2. The frame buffer of Claim 1 wherein said memory cells comprise dynamic random access memory cells.

3. The frame buffer of Claim 1 and further comprising circuitry for writing to a selected number of said cells of said array, said selected number being less than said predetermined number of terminals.

4. The frame buffer of Claim 1 wherein said array has a storage capacity of 1.5 Mbytes.

5. The frame buffer of Claim 3 wherein said circuitry for writing comprises write-per-bit circuitry.

6. The frame buffer of Claim 1 wherein said predetermined number of terminals is at least 64.

7. A frame buffer fabricated on a single chip comprising:
a memory array having a capacity preselected to store a frame of display data and an amount of additional information with minimal unused memory space; and
a data port for independently supporting a data bus at least 64-bits wide.

8. The frame buffer of Claim 7 and further comprising circuitry for accessing selected cells in said array, said circuitry for accessing including circuitry for modifying said display data on a pixel by pixel basis.

9. The frame buffer of Claim 8 wherein said circuitry for modifying comprises write-per-bit circuitry.

10. The frame buffer of Claim 7 wherein said frame buffer comprises a synchronous DRAM.

11. The frame buffer of Claim 7 wherein said frame buffer wherein said array has a maximum capacity of 1.5 MBytes.

12. The frame buffer of Claim 7 wherein said circuitry for accessing provides access to a 64-bit location in said array response to received row and column addresses.

13. The frame buffer of Claim 12 wherein said row and column addresses are received word serially in response to a row address strobe and a column address strobe.

14. A display subsystem comprising:
a display device operable to display images as frames of a predetermined number of pixels, each said pixel defined by a word of pixel data; and
a single-chip frame buffer having a storage capacity optimized to store words of said pixel data defining a said frame with a minimal number of excess cells.

15. The display subsystem of Claim 14 wherein said frame buffer further comprises a data port at least 64 bits wide.

16. The display subsystem of Claim 15 wherein said frame buffer has a maximum capacity of 1.5 MBytes.

17. The display subsystem of Claim 15 and further comprising:
a display controller for controlling the exchange of data between said frame buffer and said display device; and
a data bus at least 64-bits wide coupling said display controller and said data port of said frame buffer.

18. A method of constructing a frame buffer comprising the steps of:
providing an array of memory cells, a size of the array selected as required store a frame of pixel data defining an image to be displayed on a selected display device with minimal excess cells; and
providing a selected number of terminals for accessing the array, the number of terminals selected as required for the frame buffer to independently support an selected data bus.

19. The method of Claim 18 wherein said minimal number of excess cells provide a sufficient capacity to store icons.

20. The method of Claim 18 wherein said minimal number of excess provide a sufficient capacity to provide off-screen storage.

21. The method of Claim 18 wherein said selected data bus is at least 64 bits wide.
